# EUROPEAN PATENT APPLICATION

(11) **EP 2 224 268 A2**
(43) Date of publication of application: **01.09.2010**
(21) Application number: 10154593.7
(22) Date of filing: 24.02.2010
(51) Int. Cl.: G01V 3/14

(54) **Screening system and method**

(30) Priority: 25.02.2009 US 392729
(71) Applicant: Morpho Detection, Inc., Newark, CA 94560 (US)
(72) Inventor: Crowley, Christopher W., San Diego, CA CA 92122 (US); Boudries, Hacene, Andover, MA MA 01810 (US); Magnuson, Erik, Cardiff by the Sea, CA CA 92007 (US)
(74) Representative: Smaggasgale, Gillian Helen

(57) **Abstract**

A method of operating a screening system includes applying an electromagnetic field to a specimen in a region at least partially enclosed by electromagnetic shielding and measuring an output from a sensor, wherein the output is induced by an interaction of the electromagnetic field and the specimen. The method also includes dislodging trace particles from the specimen within the region, collecting the trace particles, and identifying the trace particles. The method further includes evaluating an association of the specimen with a substance based on the measured sensor output and the identified trace particles.

## Description

### BACKGROUND OF THE INVENTION

The embodiments described herein relate generally to screening systems, and more particularly, to a screening system for use at passenger terminals to improve detection of explosives, narcotics or other contraband during passenger handling in a transportation terminal and a method of operating the same.

To facilitate preventing passengers boarding an aircraft or other carrier from carrying concealed weapons, explosives, or other contraband, passengers are screened prior to boarding. For example, passengers arriving at an airport terminal submit to an identity verification process and are requested to walk through a metal detector. In addition, the passengers' checked and carry-on luggage may be screened for evidence of concealed weapons, explosives, or other contraband.

While the current passenger screening process is reliable, there is typically no direct examination of the passengers for trace particles of explosives, narcotics or other contraband. This is due in part to the fact that an accuracy and reliability of such trace particle examinations would be decreased by the tendency of minute trace particles to diffuse rapidly in an open and relatively well-ventilated space such as a transportation terminal. It is also due in part to the fact that such examinations would increase a time and a cost required for, and therefore decrease an efficiency of, the security screening process at a transportation terminal.

### BRIEF DESCRIPTION OF THE INVENTION

In one aspect, a method of operating a screening system is provided. The method includes applying an electromagnetic field to a specimen in a region at least partially enclosed by electromagnetic shielding and measuring an output from a sensor, wherein the output is induced by an interaction of the electromagnetic field and the specimen. The method also includes dislodging trace particles from the specimen within the region, collecting the trace particles, and identifying the trace particles. The method further includes evaluating an association of the specimen with a substance based on the measured sensor output and the identified trace particles.

In another aspect, a screening system is provided. The system includes an electromagnetic shield disposed to at least partially enclose a region, wherein the electromagnetic shield creates a barrier to airflow into and out of the region. The system also includes a source configured to generate an electromagnetic field within the region, and a sensor configured to produce an output induced by an interaction of the electromagnetic field and a specimen located in the region. The system further includes a detector configured to identify trace particles in the region, and a processor configured to facilitate evaluating an association of the specimen with a substance based on the sensor output and the identified trace particles.

In yet another aspect, a computer program embodied on a computer-readable medium is provided. The computer program includes at least one code segment that configures a processor to activate a source to generate an electromagnetic field within a region at least partially enclosed by an electromagnetic shield, wherein the electromagnetic shield creates a barrier to airflow into and out of the region. The at least one code segment also configures the processor to measure the output of a sensor, wherein the output is induced by an interaction of the electromagnetic field and a specimen located in the region. The at least one code segment further configures the processor to activate a detector to identify trace particles captured in the region, and to evaluate an association of the specimen with a substance based on the sensor output and the identified trace particles.

### BRIEF DESCRIPTION OF THE DRAWINGS

Figures 1-13 show exemplary embodiments of the systems and methods described herein.

Figure 1 is a right perspective view of an exemplary screening system;

Figure 2 is a front view of the exemplary screening system shown in Figure 1;

Figure 3 is a side section view of the exemplary screening system shown in Figure 1;

Figure 4 is a simplified block diagram of an exemplary screening system;

Figure 5 is a right perspective view of an alternative embodiment of the exemplary screening system shown in Figures 1-4;

Figure 6 is a schematic illustration of an exemplary electromagnetic field screening system that may be used with the exemplary screening system shown in Figures 1-4;

Figure 7 is a right perspective view of an exemplary screening system as shown in Figures 1-4 including the electromagnetic field screening system shown in Figure 6;

Figure 8 is a schematic illustration of a portion of the exemplary electromagnetic field screening system shown in Figure 7;

Figure 9 is a schematic illustration of an exemplary trace detection system that may be used with the exemplary screening system shown in Figures 1-4;

Figure 10 is a right perspective view of an exemplary screening system as shown in Figures 1-3 including an exemplary trace detection system;

Figure 11 is a schematic illustration of a portion of an exemplary metal detection system that may be used with the exemplary screening system shown in Figures 1-4;

Figure 12 is a right perspective view of an exemplary screening system including an exemplary passenger position verification system;

Figure 13 is a flowchart illustrating an exemplary method of operating a screening system.

### DETAILED DESCRIPTION OF THE INVENTION

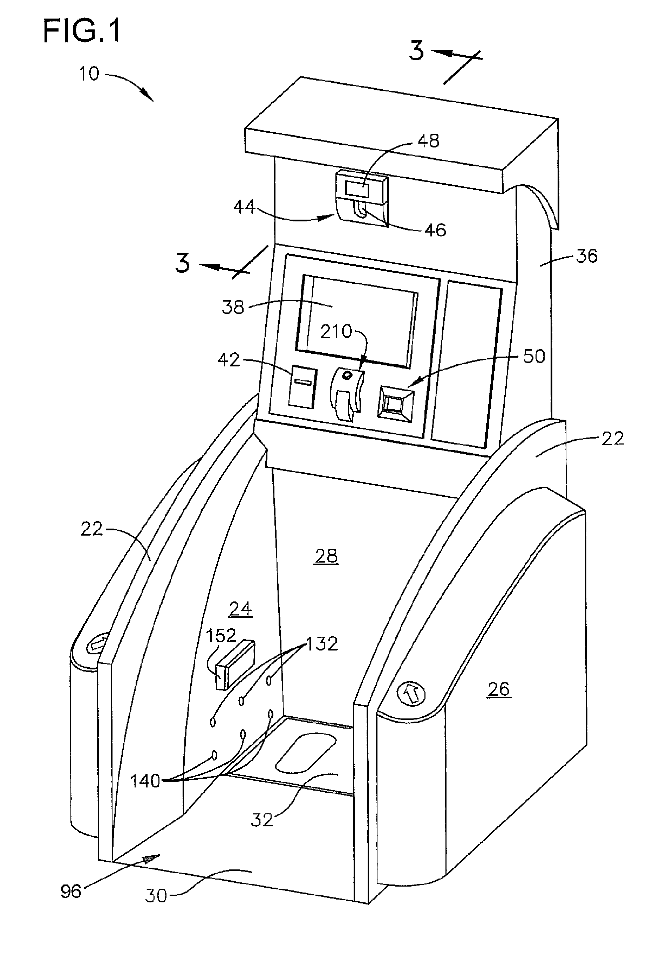

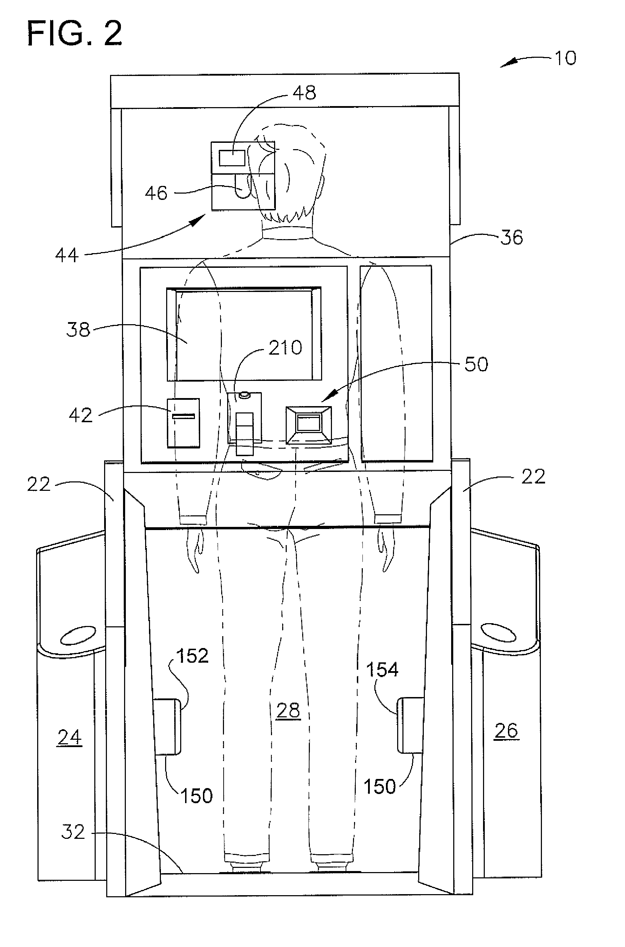

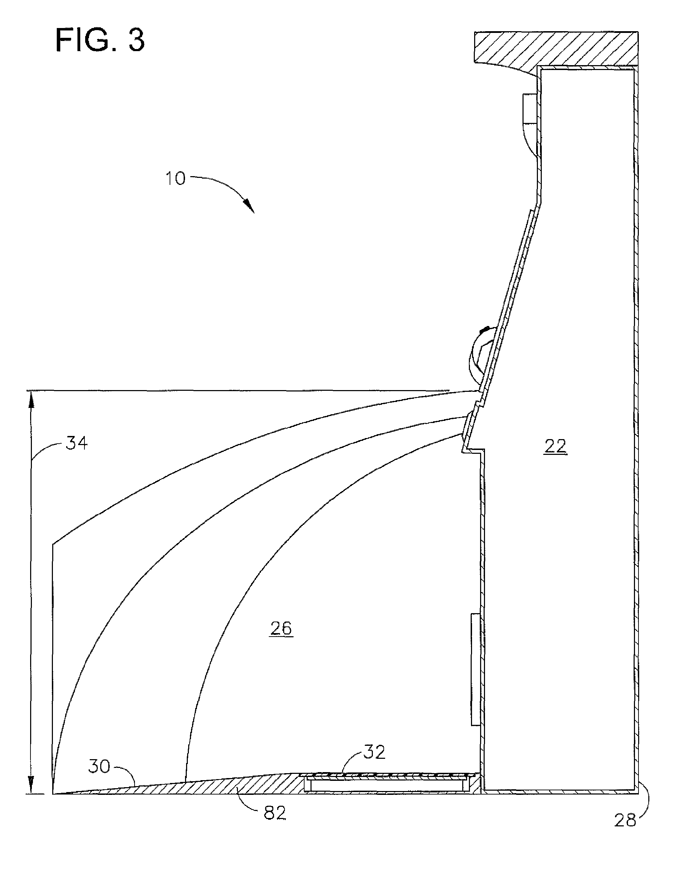

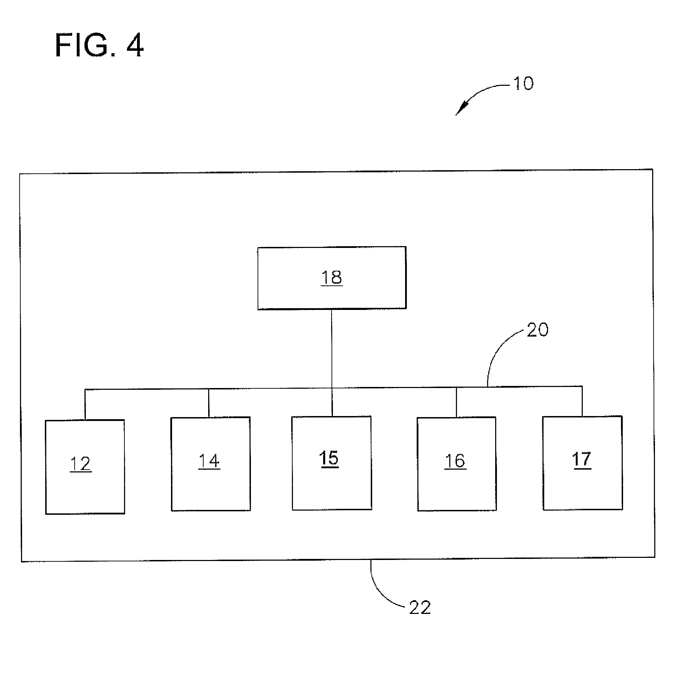

Figure 1 is a right perspective view of an exemplary screening system 10. Figure 2 is a front view of the exemplary screening system shown in Figure 1, Figure 3 is a side section view of the exemplary screening system 10 shown in Figure 1, and Figure 4 is a simplified schematic illustration of the exemplary screening system 10. As shown in Figure 4, and in the exemplary embodiment, system 10 includes at least a first modality 12, referred to herein as an electromagnetic field screening system 12, and a second modality 14, referred to herein as a trace detection system 14. In certain embodiments, screening system 10 also includes one or more of a third modality 15, referred to herein as a passenger identification verification system 15, a fourth modality 16, referred to herein as a metal detection system 16, and a fifth modality 17, referred to herein as a passenger position verification system 17. Screening system 10 further includes a processor 18 and a communications bus 20 that is coupled between modalities 12, 14, 15, 16 and 17 and processor 18.

As used herein, the term processor is not limited to just those integrated circuits referred to in the art as a computer, but broadly refers to a microcontroller, a microcomputer, a programmable logic controller (PLC), an application specific integrated circuit, and other programmable circuits, and these terms are used interchangeably herein. In certain embodiments, processor 18 may refer not to a single physical processor unit, but instead to multiple processors operating in linked or independent fashion. Processor 18 is typically configured by at least one code segment of a computer program embodied on a computer-readable medium.

Communications bus 20 enables operator commands to be sent to at least one of modalities 12, 14, 15, 16 and 17 and to allow outputs generated by modalities 12, 14, 15, 16 and 17 to be delivered to processor 18 and thus utilized by processor 18, and/or by an operator of processor 18. In one embodiment, modalities 12, 14, 15, 16 and 17 are hardwired to processor 18. In another embodiment, modalities 12, 14, 15, 16 and 17 communicate wirelessly with processor 18. In certain embodiments, communications bus 20 is a local area network. Optionally, communications bus 20 includes an internet connection.

In the exemplary embodiment, modalities 12, 14, 15, 16 and 17 and processor 18 are each housed within a single kiosk or housing 22. Optionally, processor 18 is housed separately from kiosk 22 and electronically coupled to modalities 12, 14, 15, 16 and 17 utilizing bus 20. As used herein, a kiosk is defined as an area large enough to accommodate from one to several persons that is at least partially enclosed by at least one wall.

Referring again to Figures 1-3, in an exemplary embodiment kiosk 22 includes a first wall 24, a second wall 26 that is positioned substantially parallel to first wall 24, and a third wall 28 that is positioned substantially perpendicular to and coupled between first wall 24 and second wall 26. Kiosk 22 also includes a floor 30 extending between first wall 24, second wall 26, and third wall 28. In an exemplary embodiment, floor 30 includes an inductive sensor unit 32 as described further below. For example, and as shown in Figures 1 and 2, first wall 24, second wall 26, and third wall 28 define a single opening or entrance 96 such that a passenger may enter and exit kiosk 22 through the same opening 96.

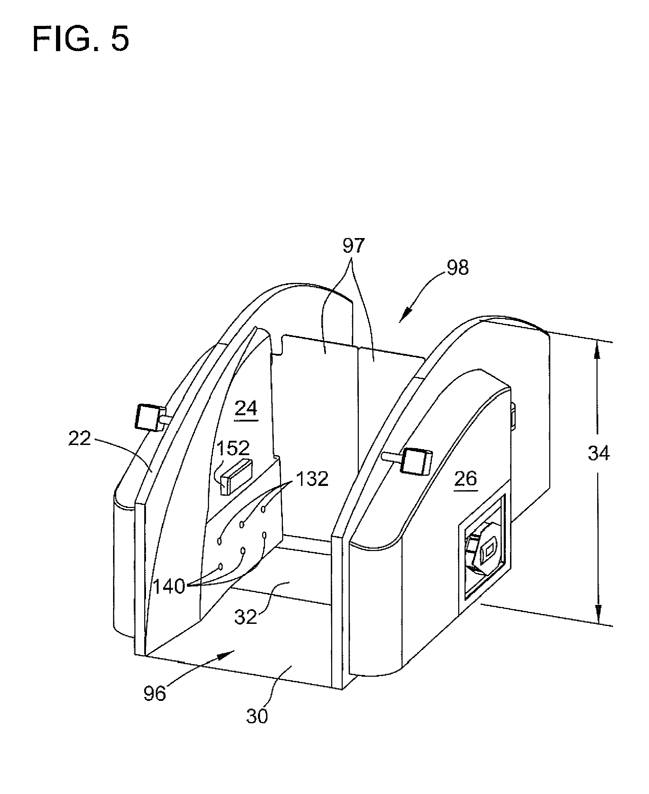

In an alternative embodiment shown in Figure 5, kiosk 22 includes first wall 24 and second wall 26, but has no third wall 28 coupled between them, such that the passenger may enter kiosk 22 through first opening 96, traverse forward through kiosk 22, and exit kiosk 22 through a second opening 98 opposite first opening 96. In this alternative embodiment, kiosk 22 also includes floor 30 extending between first wall 24 and second wall 26, and floor 30 includes the inductive sensor unit 32 as described further below. In addition, the alternative embodiment of Figure 5 may optionally include swinging doors 97.

In the exemplary embodiments shown in Figures 1-3 and in Figure 5, the kiosk walls each have a height 34 of between approximately 28 - 42 inches. These exemplary embodiments show the first wall 24 and second wall 26 formed with an approximate arcuate shape having a radius which approximates the height of the walls. In certain embodiments, the arcuate shape of first wall 24 and second wall 26 is truncated at the entrance 96, and in the case of the embodiment shown in Figure 5, at the exit 98, to facilitate the movement of people into and out of system 10, and to further extend the notion of openness of the system 10. In alternative embodiments, kiosk walls 24 and 26 have a height 34 that is greater than a height of a typical passenger, i.e. like a phone booth for example, such that the entire body of the passenger may be screened.

In an exemplary embodiment, first wall 24, second wall 26 and floor 30 include elements of electromagnetic field (EMF) screening system 12. In the exemplary embodiment shown in Figures 1-3, elements of electromagnetic field (EMF) screening system 12 may also be included in third wall 28. Further, in certain embodiments, EMF screening system 12 is implemented as a quadrupole resonance (QR) detection system 12. Quadrupole resonance detection system 12 utilizes quadrupole resonance to detect contraband, including explosives such as, but not limited to C4, Semtex, Detasheet, TNT, ANFO, and/or HMX, on the basis that the quadrupole resonance signature of these explosives is unique.

Nuclear Quadrupole Resonance (NQR) is a branch of radio frequency spectroscopy that exploits the inherent electrical properties of atomic nuclei and may therefore be utilized to detect a wide variety of potentially explosive materials. For example, nuclei having non-spherical electric charge distributions possess electric quadrupole moments. Quadrupole resonance arises from the interaction of the nuclear quadrupole moment of the nucleus with the local applied electrical field gradients produced by the surrounding atomic environment. Any chemical element having a nucleus with a spin quantum number greater than one-half can exhibit quadrupole resonance. Such quadrupolar nuclei include: ⁷Li, ⁹Be, ¹⁴N, ¹⁷O, ²³Na, ²⁷Al, ³⁵Cl, ³⁷Cl, ³⁹K, ⁵⁵Mn, ⁷⁵As, ⁷⁹Br, ⁸¹Br, ¹²⁷I, ¹⁹⁷Au, and ²⁰⁹Bi_{.} Many substances containing such nuclei, approximately 10,000, have been identified that exhibit quadrupole resonance.

It so happens that some of these quadrupolar nuclei are present in explosive and narcotic materials, among them being ¹⁴N, ¹⁷O, ²³Na, ³⁵Cl, ³⁷Cl, and ³⁹K. The most studied quadrupolar nucleus for explosives and narcotics detection is nitrogen. In solid materials, electrons and atomic nuclei produce electric field gradients. These gradients modify the energy levels of any quadrupolar nuclei, and hence their characteristic transition frequencies. Measurements of these frequencies or relaxation time constants, or both, can indicate not only which nuclei are present but also their chemical environment, or, equivalently, the chemical substance of which they are a part. Thus, detection of quadrupolar nuclei may be used to evaluate whether a specimen being screened is associated with a certain substance, for example, explosives, narcotics or other contraband.

When an atomic quadrupolar nucleus is within an electric field gradient, variations in the local field associated with the field gradient affect different parts of the nucleus in different ways. The combined forces of these fields cause the quadrupole to experience a torque, which causes it to precess about the electric field gradient. Precessional motion generates an oscillating nuclear magnetic moment. An externally applied radio frequency (RF) magnetic field in phase with the precessional frequency of the quadrupolar nucleus can tip the orientation of the nucleus momentarily. The energy levels are briefly not in equilibrium, and immediately begin to return to equilibrium. As the nuclei return, they produce an RF signal, known as the free induction decay (FID). A pick-up coil detects the signal, which is subsequently amplified by a sensitive receiver to measure its characteristics.

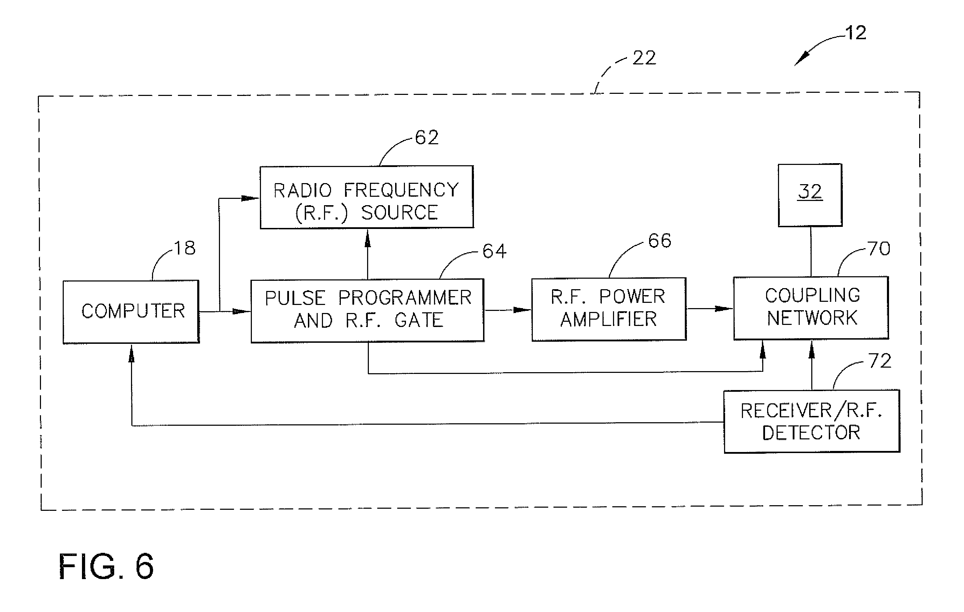

Figure 6 is a simplified schematic illustration of an exemplary quadrupole resonance system 12 that includes a radio frequency (RF) source 62, a pulse programmer and RF gate 64 and an RF power amplifier 66 that are configured to generate a plurality of radio frequency pulses having a predetermined frequency to be applied to a coil such as sensor 32 (also shown in Figures 1-3). A communications network 70 conveys the radio frequency pulses from radio frequency source 62, pulse programmer and RF gate 64 and RF power amplifier 66 to sensor 32 that, in the exemplary embodiment, is positioned within kiosk 22. The communications network 70 also conducts the signal from sensor 32 to a receiver/RF detector 72 after the passenger is irradiated with the radio frequency pulses.

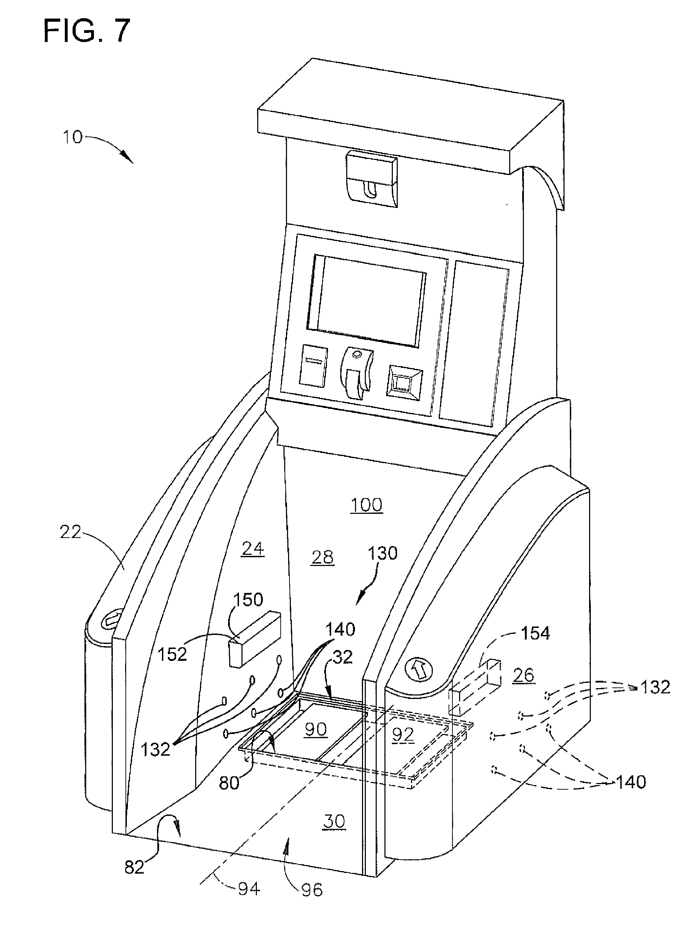

Figure 7 is a right perspective view of an exemplary embodiment of kiosk 22 including quadrupole resonance (QR) detection system 12. As stated above, quadrupole resonance (QR) detection system 12 includes inductive sensor 32. In the exemplary embodiment, inductive sensor 32 is positioned within a recessed region 80 of floor 30, between an entrance ramp 82 and third wall 28. This recessed region 80 may also be referred to as the sensor housing. In alternative embodiments that do not include third wall 28, sensor 32 is positioned on or within floor 30 approximately halfway between entrance 96 and exit 98, as shown in Figure 5.

As shown in Figure 7, and in the exemplary embodiment, inductive sensor 32 may be implemented using two anti-symmetric current branches 90 and 92 that may be located on opposing sides of a medial plane 94. Specifically, current branch 90 is positioned on one side of medial plane 94, while current branch 92 is positioned on the opposite side of medial plane 94.

Inductive sensor 32 may be configured such that both current branches 90 and 92 experience current flow that is generally or substantially parallel to the left and right walls 24 and 26, but opposite in direction. For example, the current branches 90 and 92 may be placed in communication with an electrical source (not shown in this figure). During operation, current flows through current branch 90 in one direction, while current flows through current branch 92 in substantially the opposite direction. The term "anti-symmetric current flow" may be used to refer to the condition in which current flows through the current branches in substantially opposite directions.

In the exemplary embodiment, inductive sensor 32 is implemented as a quadrupole resonance (QR) sensor. For convenience only, various embodiments will be described with reference to the inductive sensor 32 implemented as QR sensor 32, but such description is equally applicable to other types of inductive sensors.

In the exemplary embodiment, current branches 90 and 92 collectively define a QR sheet coil sensor 32. For convenience only, further discussion of the QR sensor will primarily reference a "QR sheet coil," or simply a "QR coil". During a typical screening process, a passenger enters the system at entrance 96, and then stands within a screening region defined by QR sensor 32. Specifically, the passenger may stand with his or her left foot positioned relative to current branch 90 and his or her right foot positioned relative to current branch 92. The QR sensor then performs a screening process using nuclear quadrupole resonance (NQR) to detect the presence of a target substance associated with the passenger.

As shown in Figure 6, QR sensor 32 is in communication with the RF subsystem, defined generally herein to include radio frequency source 62, pulse programmer and RF gate 64, and RF power amplifier 66 which provides electrical excitation signals to current branches 90 and 92. The RF subsystem may utilize a variable frequency RF source to provide RF excitation signals at a frequency generally corresponding to a predetermined, characteristic NQR frequency of a target substance. During the screening process, the RF excitation signals generated by the RF source may be introduced to the specimen, which may include, for example, the shoes, socks, and clothing present on the lower extremities of a passenger standing or otherwise positioned relative to the QR sensor 32. In the exemplary embodiment, the QR coil 32 also functions as a pickup coil for NQR signals generated by the specimen, thus providing an NQR output signal which may be sampled to determine the presence of a target substance, such as an explosive, utilizing processor 18, for example.

Returning to Figure 7, in the exemplary embodiment, an EMI/RFI (electromagnetic interference/radio frequency interference) shield facilitates shielding sensor 32 from external noise and interference and/or inhibiting RFI from escaping from the screening system during a screening process. In the exemplary embodiment of Figures 1-3, walls 24, 26, and 28 are configured to perform electromagnetic shielding for QR sensor 32. Specifically, walls 24, 26, and 28 are electrically connected to each other, to entrance ramp 82, and to sensor housing 80 to form an electromagnetic shield 100. Thus, the specimen is scanned within a region at least partially enclosed by electromagnetic shield 100. In alternative embodiments that do not include third wall 28, such as the exemplary embodiment shown in Figure 5, first wall 24 and second wall 26 extend past sensor 32 towards exit 98 to provide additional shielding, and/or optional swinging doors 97 may be used to provide additional shielding.

In the exemplary embodiment, each of the shielding components, for example walls 24, 26, and 28, is fabricated from a suitably conductive material such as aluminum or copper. Further in the exemplary embodiment, the floor components, for example ramp 82 and sensor housing 80, are welded together to form a unitary structure. Walls 24, 26, and 28 may be welded to the floor components, or secured using fasteners such as bolts, rivets, pins, or any other suitable method. Further, QR sensor 32 may be secured within sensor housing 80 using, for example, any of the just-mentioned fastening techniques or any other suitable methods. If desired, walls 24, 26, and 28, entrance ramp 82, and the QR sensor 32 may be covered with non-conductive materials such as wood, plastic, fabric, fiberglass, and the like.

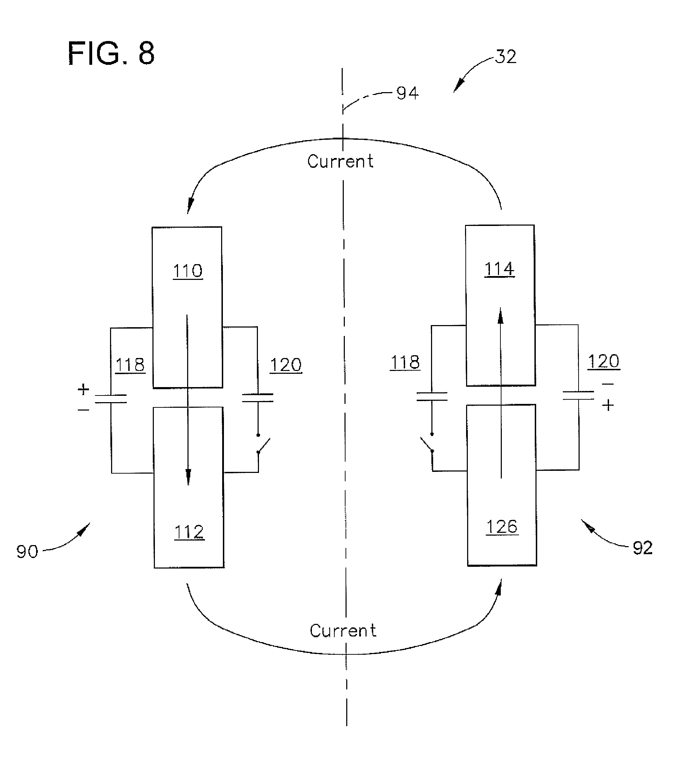

Figure 8 is a simplified schematic illustration of the exemplary QR sensor 32 shown in Figure 7. Left current branch 90 is shown having upper and lower conductive elements 110 and 112, which are separated by a non-conductive region. Similarly, right current branch 92 includes upper and lower conductive elements 114 and 116, which are also separated by a non-conductive region. The left and right current branches 90 and 92 collectively define the QR coil of sensor 32, and may be formed from any suitably conductive materials such as copper or aluminum, for example.

No particular length or width for the current branches 90 and 92 is required. In the exemplary embodiment, each current branch is dimensioned so that it is slightly larger than the typical object or specimen to be inspected. Generally, current branches 90 and 92 are sized such that a passenger's left foot and right foot (with or without shoes) may be placed in close proximity to the left and right current branches 90 and 92, respectively. This may be accomplished by instructing the passenger to stand over the left and right current branches. In the exemplary embodiment, the left and right branches may each have a width of about 4-8 inches and a length of about 12- 24 inches. It is to be understood that the terms "left" and "right" are merely used for expositive convenience and are not definitive of particular sides of the structure.

In the exemplary embodiment, upper and lower conductive elements 110 and 112 are electrically coupled by a fixed-valued resonance capacitor 118 and a tuning capacitor 120, which is a switched capacitor that is used to vary tuning capacitance. Upper and lower conductive elements 114 and 116 may be similarly configured.

Figure 8 also includes several arrows which show the direction of current flow through the left and right current branches 90 and 92 which in the exemplary embodiment, is in a counter-clockwise direction. During operation, current flows through left current branch 90 in one direction, while current flows through right current branch 92 in substantially the opposite direction. This is because the left and right current branches 90 and 92 each have a different arrangement of positive and negative conductive elements. For instance, left current branch 90 includes a positive upper conductive element 110 and a negative lower conductive element 112. In contrast, right current branch 92 includes a negative upper conductive element 114 and a positive lower conductive element 116. This arrangement is one example of a QR sensor providing counter-directed or anti-symmetric current flow through the current branches.

Returning to Figure 7, in accordance with the exemplary embodiment, current flows between the left and right current branches 90 and 92 during operation since these components are electrically coupled via ramp 82 and the sensor housing 80. During operation, a passenger may place his or her left foot over left current branch 90 and his or her right foot over right current branch 92. In such a scenario, current is directed oppositely through each branch resulting in current flowing from toe to heel along left current branch 90, and from heel to toe along right current branch 92. In the exemplary embodiment, QR sensor 32 is positioned within sensor housing 80 to form a non-conductive gap between current branches of the QR sensor. This gap allows the magnetic fields to circulate about their respective current branches.

In contrast to conventional inductive sensor systems, the counter-directed magnetic fields generated by QR sensor 32 are well-attenuated and have a topography that is especially suited for use with a kiosk that includes a first wall 24, a second wall 26 that is opposite to first wall 24, and a floor 30 that is connected to first wall 24 and second wall 26.

As an example of a practical application, the left and right current branches 90 and 92 may be positioned about 2-7 inches from respective walls 24 and 26 using a plurality of non-conductive regions. In addition, current branches 90 and 92 may be positioned about 4-14 inches from each other, separated by a non-conductive region.

EMF screening system 12 is thus useful for evaluating, during passenger screening at a transportation terminal, whether a specimen is associated with a substance, for example, explosives, narcotics or other contraband. Nevertheless, a direct examination of the passenger for trace particles of explosives, narcotics or other contraband would facilitate an improvement in the range and accuracy of detection. Such examinations for trace particles are typically rendered inaccurate or unreliable by the tendency of minute trace particles to diffuse rapidly in an open and relatively well-ventilated space such as a transportation terminal. In addition, such examinations typically increase a time and a cost required for, and therefore decrease an efficiency of, the security screening process at a transportation terminal.

However, an unexpected benefit of the use of electromagnetic shield 100 for EMF screening system 12 is that electromagnetic shield 100 creates a barrier to airflow into and out of kiosk 22. Thus, electromagnetic shield 100 creates a region of still air 130 about the specimen being scanned. In the exemplary embodiment shown in Figures 1-3, electromagnetic shield 100 includes first wall 24, second wall 26, and third wall 28 that together create region of still air 130. In alternative embodiments such as that shown in Figure 5, with no third wall 28, electromagnetic shield 100 includes first wall 24 and second wall 26 that extend towards exit 98, and may optionally include swinging doors 97.

With reference to Figures 1, 4, 5 and 9, in certain embodiments screening system 10 includes trace detection system 14 to take advantage of the unexpected benefit provided by region of still air 130. The specimen being scanned may include, for example, the shoes, socks, and clothing present on the lower extremities of a passenger standing or otherwise positioned relative to the QR sensor 32. Embodiments of trace detection system 14 facilitate dislodging, collecting and identifying trace particles from the specimen within the region of still air 130 during the screening process.

In the exemplary embodiment, trace detection system 14 includes one or more nozzles 132 to facilitate dislodging trace particles from the specimen. In the exemplary embodiment, nozzles 132 are installed in first wall 24 and second wall 26 and spaced linearly in each wall, each approximately 4 inches apart from the next, such that the nozzles 132 are approximately 8 inches above floor 30. Nozzles 132 spray air routed from a supply source 134 into the region of still air 130. In alternative embodiments, gases or gas mixtures other than air are sprayed. In certain embodiments, some nozzles 132 are configured to spray at different angles relative to the floor and/or first wall 24 and second wall 26 than are other nozzles 132. In certain embodiments, some or all nozzles 132 are located in third wall 28 and/or floor 30.

Further in the exemplary embodiment, processor 18 controls the spray of air by communicating via bus 20 with supply valve 136. Processor 18 opens supply valve 136 briefly, for example, but not by way of limitation, for about one-half second, to allow air to flow through supply line 138 and nozzles 132 into the region of still air 130. The spray from nozzles 132 disturbs the air proximate the specimen, in turn causing trace particles to dislodge from the specimen and become temporarily suspended in the region of still air 130. Electromagnetic shield 100 serves as a barrier to airflow that facilitates the containment of any dislodged trace particles within the region of still air 130, and simultaneously facilitates preventing contamination of the region of still air 130 with trace particles not arising from the specimen.

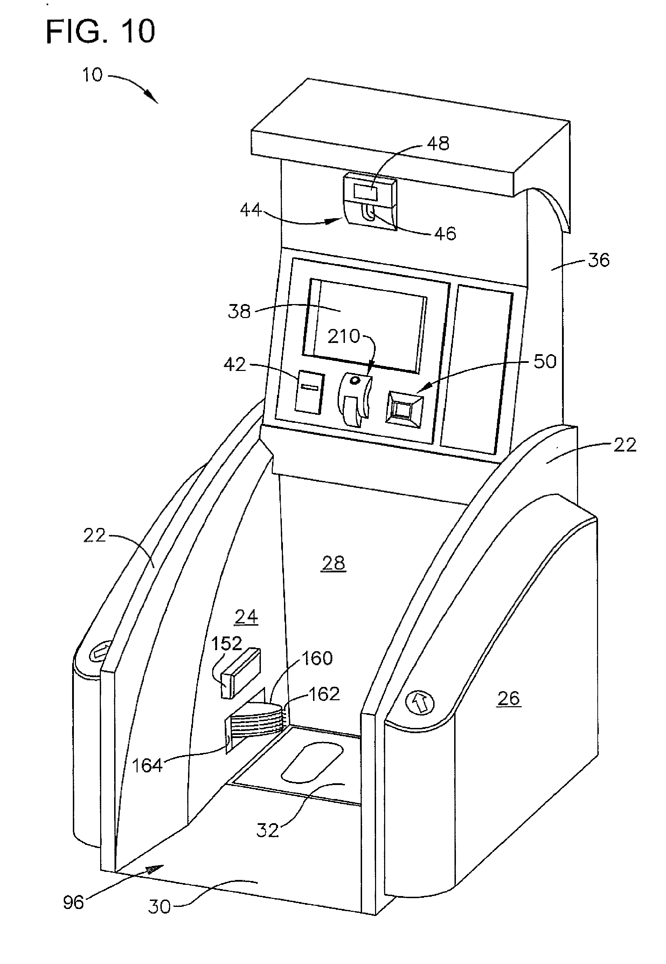

In alternative embodiments, other mechanisms are used to dislodge trace particles from the specimen. For example, but not by way of limitation, in an exemplary embodiment as shown in Figure 10, one or more brushes 160 are installed in floor 30, first wall 24, second wall 26, and/or third wall 28 if present. Each brush 160 includes a plurality of bristles 162 that are rubbed against the specimen, for example through rotational or linear mechanical motion, to dislodge trace particles.

Returning to the exemplary embodiments of Figures 1, 4, 5 and 9, trace detection system 14 also includes one or more air intakes 140 to collect trace particles from the region of still air 130. In the exemplary embodiment, air intakes 140 are installed in first wall 24 and second wall 26 and spaced linearly in each wall, each approximately 4 inches apart from the next, such that the air intakes 140 are approximately 3 inches above floor 30. In certain embodiments, some or all air intakes 140 are located in third wall 28, if present, and/or in floor 30.

Air from the region of still air 130 is captured by air intakes 140 through the action of intake motor 146. In the exemplary embodiment, intake motor 146 includes at least one fan. In certain embodiments, intake motor 146 includes at least one vacuum generator. In the exemplary embodiment, processor 18 controls the collection of air by communicating via bus 20 with intake valve 142. Processor 18 controls the intake of air by opening intake valve 142, for example, but not by way of limitation, for a period of about two seconds after the spray of air from nozzles 132 is completed, to capture air from the region of still air 130 through intake line 144. In alternative embodiments, processor 18 activates and deactivates intake motor 146 directly to control air capture through air intakes 140.

Further in the exemplary embodiment, trace particles are identified in the air delivered through intake line 144 by a detector 148, which uses any suitable trace particle detection technology. For example, but not by way of limitation, detector 148 may be an ion mobility spectrometer that analyzes trace particles in the air delivered through intake line 144. In the exemplary embodiment, detector 148 is an ion trap mobility spectrometer. The output of detector 148 may be analyzed by processor 18, and/or by an operator of processor 18, to evaluate whether the screened specimen is associated with a substance, such as explosives, narcotics or other contraband.

In alternative embodiments, other mechanisms are used to collect trace particles from the specimen. For example, but not by way of limitation, in an exemplary embodiment as shown in Figure 10, one or more brushes 160 installed in floor 30, first wall 24, second wall 26, and/or third wall 28, if present, rotate on an axis approximately perpendicular to floor 30. Each brush 160 includes a plurality of bristles 162 that rotate against the specimen and capture trace particles on the brush bristles 162. Upon further rotation of the brushes 160, the trace particles are stripped from the brush bristles 162 by stripping device 164, for example an adhesive or friction strip, and transferred to detector 148 by any suitable method.

In certain embodiments, trace detection system 14 also includes a fingertip trace detection system 210, as shown in the exemplary embodiment of Figures 1 and 2. Fingertip trace detection system 210 is located to detect minute particles of interest such as traces of narcotics, explosives, and other contraband on the passenger's finger or hand, for example. In the exemplary embodiment, fingertip trace detection system 210 is located proximate to a boarding pass scanner (not shown) such that as the passenger scans the boarding pass, at least a portion of the passenger's hand approximately simultaneously passes over fingertip trace detection system 210. In alternative embodiments, the passenger is prompted to press a button to activate fingertip trace detection system 210 such that trace materials on the surface of the button-pressing finger are collected and then analyzed by fingertip trace detection system 210. As such, fingertip trace detection system 10 is configured to determine when a passenger's finger has been placed over the device to activate the fingertip trace screening procedure. In the exemplary embodiment, fingertip trace detection system 210 includes an ion trap mobility spectrometer (not shown) to identify trace particles that may be indicative of the passenger recently manipulating explosives or other contraband.

Returning to Figures 1-4, in certain embodiments, screening system 10 also includes passenger identification verification system 15. In the exemplary embodiment, kiosk 22 includes a control panel section 36 that is coupled to forward wall 28 and extends upwardly from forward wall 28 to a predetermined height to facilitate providing various operator controls. Control panel section 36 also includes a monitoring or display device 38 that may be used to prompt a passenger to input selected information into the screening system and/or prompt a passenger to perform various actions within the screening system to facilitate expedient verification of the identity of the passenger and inspection of the passenger for contraband.

In certain embodiments, to facilitate verifying a passenger's identity, screening system 10 includes an electronic card reader 42 into which a passenger enters a registration card that was obtained by the passenger during a prescreening process. In the exemplary embodiment, the passenger registration card includes biometric information of the passenger that has been encoded onto the registration card. For example, a passenger may obtain a registration card by registering with the Registered Traveler Program wherein a passenger is pre-screened by the Transportation Security Administration (TSA) or some other authorized screening entity, to obtain biometric information that is then stored on the passenger's registration card. The biometric information may include the passenger's fingerprints, iris scan information, hand print information, voice recognition information, or other suitable biometric information. The information on the registration card may, for example but not by way of limitation, be encoded on a magnetic strip, or by using optical read codes, an RF-read memory chip, or other embedded media.

Accordingly, during operation, the passenger inserts his or her registration card into electronic card reader 42. Passenger identification verification system 15 then prompts the passenger to position a selected body part on a sensor that is utilized to collect biometric information from the passenger within kiosk 22. The collected information is then compared to the biometric information stored on the registration card to verify the identity of the passenger.

In an exemplary embodiment, passenger identification verification system 15 may be implemented using an iris scan device 44 to generate biometric information that is compared to the information on the registration card in order to verify that the passenger being screened is the passenger to whom the card in fact belongs. An exemplary iris scan device 44 includes an illuminating device 46 that directs light having desired characteristics to the eye under observation such that at least one of the iris and/or pupil of the eye under observation take a characteristic shape. The exemplary iris scan device 44 also includes a light imaging apparatus 48 to generate an image of the iris and/or pupil. The generated image is then compared to information that is stored on the registration card or, optionally, information stored on processor 18. It should be realized that in the exemplary embodiment, the generated images described herein are electronically generated images or data files of an image, and not physical images. Specifically, the systems described herein generate an electronic image or datafile that is compared to an electronic image or datafile stored on the registration card or optionally within system 10 to verify the identity of the passenger.

In another exemplary embodiment, passenger identification verification system 15 may be implemented utilizing a fingerprint scan device 50 wherein a passenger places a finger on the fingerprint scan device 50 such that the device obtains an image of the fingerprint of the passenger being verified. The generated image is then compared to information that is stored on the registration card or, optionally, information stored on processor 18. It should be realized that in the exemplary embodiment, the generated images described herein are electronically generated images or data files of an image and not physical images. Specifically, the system described herein generates an electronic image or datafile that is compared to an electronic image or datafile stored on the registration card or optionally within system 10 to verify the identity of the passenger. In alternative embodiments, the passenger identification verification system 15 is implemented using a hand scanning device, a facial image recognition system and/or a voice recognition system in order to verify the identity of the passenger.

Furthermore, in certain embodiments, screening system 10 also includes metal detection system 16. Advantageously, metal detection system 16 may be implemented utilizing a plurality of metal detection coils 150, as shown in Figure 7, in conjunction with the same inductive sensor 32 that is also used in EMF screening system 12. Each of the plurality of metal detection coils 150 may be configured to detect conductive objects present on the specimen being scanned, for example, within the vicinity of the lower extremities of the inspected passenger. These signals may be communicated to a suitable computing device, for example processor 18. In certain embodiments, as shown in figures 5 and 7, the plurality of metal detection coils 150 includes a first metal detection coil 152 mounted to an inner surface of first wall 24, and a second metal detection coil 154 mounted to an inner surface of second wall 26.

In an exemplary embodiment, metal detection coils 152 and 154 are each mounted at a height above floor 30 that facilitates a metal detection screening of the lower extremities of the passenger. For example, coils 152 and 154 may be positioned approximately 12 to 40 inches above floor 30. In an exemplary embodiment, metal detection coils 152 and 154 are inductive coils such that when a first current flows through the first metal detection coil 152 in a first direction a first magnetic field is formed, and when the current flows through the second metal detection coil 154 in a second direction opposite to the first direction, a second magnetic field is formed.

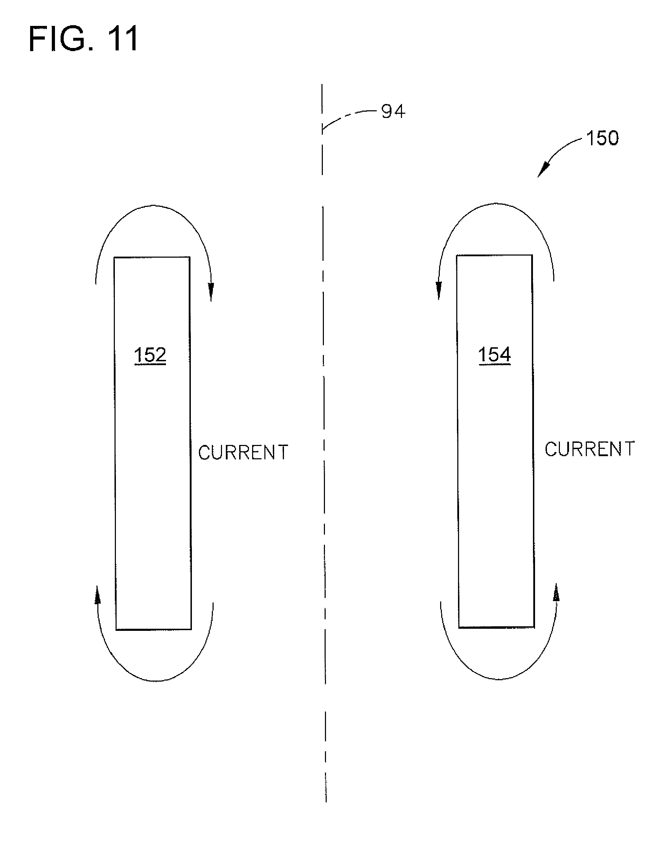

Figure 11 is a simplified schematic illustration of the metal detection coils 152 and 154 shown in Figure 7. Coil 152 and coil 154 are each separated by a non-conductive region which generally is space in which the passenger is positioned, i.e. the passenger is positioned between coils 152 and 154 to facilitate operation of the system. Coils 152 and 154 may be formed from any suitably conductive materials such as copper or aluminum, for example, and no particular length or width for the coils 152 and 154 is required. Figure 11 also includes several arrows which show the direction of current flow through coils 152 and 154, which in the exemplary embodiment is in a clockwise direction through coil 152 and in a counterclockwise direction through coil 154 such that there is no mutual inductance between the inductive sensor 32 (shown in Figure 7) and the coil pair 152 and 154. In alternative embodiments, other suitable coil arrangements and coil types may be utilized.

In the exemplary embodiment, current is supplied to coils 152 and 154 utilizing a line driver circuit or a signal driver, for example, such that each coil 152 and 154 generates a magnetic field around each respective coil. In the exemplary embodiment, the QR sensor 32 is utilized to monitor or detect any changes in the magnetic field generated by coils 152 and 154. More specifically, when no metallic object is positioned between coils 152 and 154, the coils are substantially balanced. That is, a balanced or null signal is injected into the QR sensor 32 such that QR sensor 32 does not detect any imbalance between coils 152 and 154. However, if a passenger carrying a metallic object is positioned between coils 152 and 154, the signals generated by coils 152 and 154 will become unbalanced, and a signal having some amplitude will be detected by QR sensor 32. Accordingly, when system 10 is configured to operate in the metal detection system 16 modality, QR sensor 32 is switched away from the QR driver circuit to enable the QR sensor 32 to detect any disturbances in the magnetic field generated by coils 152 and 154. In the exemplary embodiment, when the QR sensor 32 detects a change in the magnetic field generated by coils 152 and 154 that exceeds a predetermined threshold, an alarm or other indication will be enabled to prompt an operator that a metallic object has been detected and that further, more detailed screening of the passenger may be required.

Although the exemplary metal detection system 16 described herein is generally is directed toward scanning the lower region of the passenger while the passenger is still wearing shoes, in alternative embodiments metal detection system 16 may be implemented to scan the entire passenger with or without the passenger wearing shoes.

Also, in certain embodiments, screening system 10 includes passenger position verification system 17. To optimize the identification and screening operation of system 10, the passenger being inspected should be positioned within system 10 such that the passenger's feet are positioned within a predetermined screening area the provides the most optimal screening conditions for modalities 12, 14 and 16. However, the passenger to be screened generally is unaware of the most optimal screening area. Passenger position verification system 17 may be utilized to determine that the passenger's feet are within the predetermined area.

More specifically, the volume of space interrogated by EMF screening system 12, trace detection system 14 and metal detection system 16 is finite. Passenger position verification system 17 ensures that the passenger's feet remain positioned such that the passenger remains within the interrogation volume, i.e. the predetermined screening area, throughout the scan period.

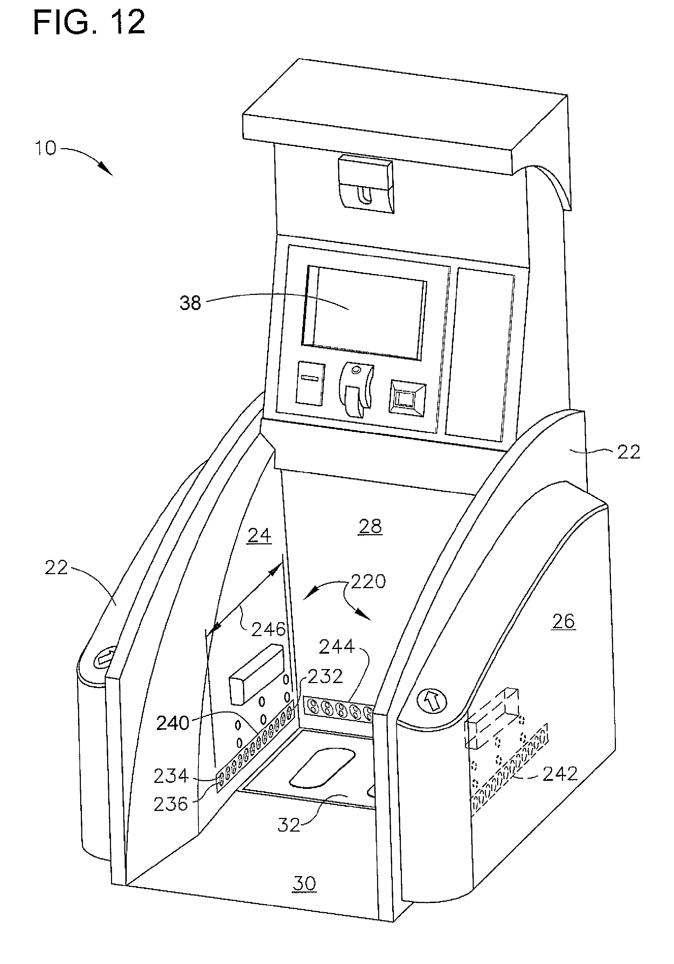

Figure 12 is a right perspective view of an embodiment of screening system 10 including an exemplary embodiment of passenger position verification system 17. In this exemplary embodiment, passenger position verification system 17 is implemented using an infrared imaging system 220. In alternative embodiments, passenger position verification system 17 is implemented using one or more of a machine vision camera system, a pressure-responsive system mounted within floor 30, an ultrasonic ranging system, a laser imaging system, or any other suitable system for determining foot location within screening system 10.

In the exemplary embodiment, infrared imaging system 220 includes a first infrared sensor array 240 that includes a plurality of infrared sensors 232. Infrared sensors 232 are spaced linearly, each approximately one inch apart from the next, such that the sensors 232 are approximately parallel to and just above floor 30. Additionally, sensor array 240 is fabricated with sufficient infrared sensors 232 to cover a predetermined length 246 that is equivalent to, or slightly larger than, a predetermined foot size of an average passenger to be screened.

In the exemplary embodiment, each infrared sensor 232 includes an infrared transmitter 234 and an infrared receiver 236. Infrared transmitter 234 is mounted proximate to its corresponding infrared receiver 236 and facing the same direction, such that when an object, such as the passenger being screened, is positioned in the path of infrared transmitter 234, the transmitted infrared beam is reflected from the passenger being screened back to the infrared receiver 236. In the exemplary embodiment, the receiver 236 generates a voltage output that is proportional to the distance to the object that is reflecting the beam.

Further in the exemplary embodiment, first sensor array 240 is positioned on first wall 24 and directed inwardly toward the screening area defined between first wall 24 and second wall 26. Also in the exemplary embodiment, a second sensor array 242 that is substantially similar to first sensor array 240 is positioned on second wall 26 and directed inwardly toward the screening area. In certain embodiments that include third wall 28, a third sensor array 244 that also is substantially similar to first sensor array 240 may be positioned on third wall 28.

During operation of system 220, when a foot is placed in the screening area, each infrared sensor 232 within first sensor array 240, second sensor array 242 and optional third sensor array 244 generates a distance measurement to the part of the foot that is in line with that respective infrared sensor 232. Specifically, each sensor 232 utilizes an angulation technique to determine the distance between each respective foot and the sensor 32. This information is then utilized to generate a distance profile of the portion of the passenger's foot that is proximate to each respective sensor array 240, 242, and 244. As a result, the distance profile will substantially describe a profile of the foot of the passenger being screened. Utilizing the distance profile generated by each respective sensor array 240, 242, and 244, a processor, such as processor 18 for example, determines at least one of the length of the foot, the distance from the foot to each respective sensor array 240, 242, and 244, the position of the foot along each respective sensor array 240, 242, and 244, and the angle of the foot with respect to each respective sensor array 240, 242, and 244. Moreover, the distance profile may also be used to estimate the width of the foot. Although the term "foot" is utilized throughout the description, it should be realized that the term "foot" generally refers to the passenger's foot and any footwear worn by the passenger during the screening process.

The distance profile is then utilized to calculate the region of the floor 30 that is covered by the foot. The calculated region is then compared to an acceptable foot placement region to determine whether the passenger's feet are properly within the predetermined screening area. If the foot is within the acceptable region, then one or more of EMF screening system 12, trace detection system 14 and metal detection system 16 may be used most effectively to screen the passenger. In certain embodiments, if a foot is not within the acceptable region, the passenger is prompted to reposition either one or both feet. System 220 is then reactivated to generate an additional distance profile as discussed above. This process is repeated until both feet are positioned within the predetermined screening area and the desired screening is completed. In the exemplary embodiment, the passenger may be prompted to reposition one or both feet utilizing either an audio or visual indicator, generated by processor 18 and displayed on screen 38, for example. In certain embodiments, system 220 includes additional sensors 232 that are mounted at different elevations relative to floor 30 to facilitate the detection of, for example, narrow high-heeled shoes, and thus improve the performance of system 220.

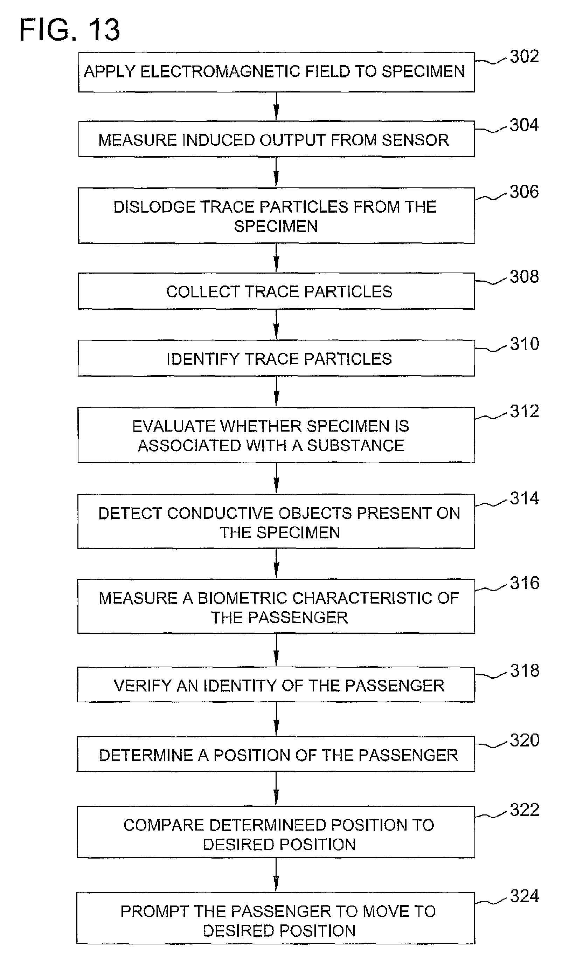

Figure 13 is a flowchart illustrating an exemplary method 300 of operating screening system 10. The method includes applying 302 an electromagnetic field to a specimen in a region at least partially enclosed by electromagnetic shielding and measuring 304 an output from a sensor induced by an interaction of the electromagnetic field and the specimen. For example, as shown in Figure 6, the electromagnetic field may be applied by radio frequency source 62, pulse programmer and RF gate 64, and RF power amplifier 66, the induced output may be measured by QR sensor 32, and the electromagnetically shielded region may be the region of still air 130 at least partially enclosed by electromagnetic shield 100 (as shown in Figure 7).

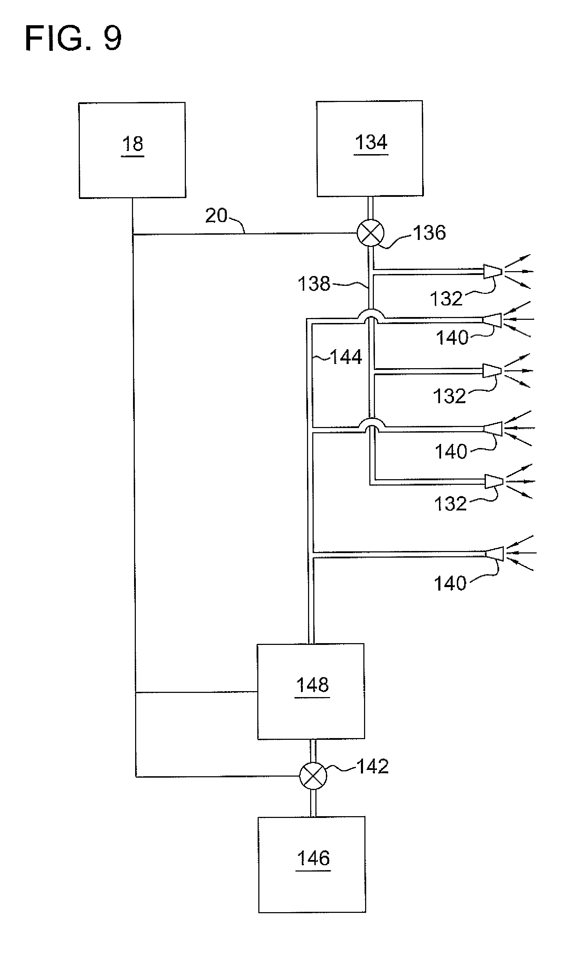

Method 300 also includes dislodging 306 trace particles from the specimen within the region, collecting 308 the trace particles, and identifying 310 the trace particles. For example, as shown if Figure 9, one or more nozzles 132 may be used to dislodge the trace particles within the region of still air 130, one or more air intakes 140 may be used to collect the trace particles, and detector 148 may be used to identify the trace particles. Finally, the method includes evaluating 312 an association of the specimen with a substance based on the measured sensor output and the identified trace particles. For example, the outputs of QR sensor 32 and detector 148 may be analyzed by processor 18 to evaluate whether a passenger is in the possession of, or has been in the presence of, a substance such as explosives, narcotics or other contraband.

In certain embodiments, method 300 also includes detecting 314 conductive objects present on the specimen, for example by using an embodiment of metal detection system 16 as shown in Figures 1, 5 and 11. Furthermore, in certain embodiments, wherein the specimen being screened is a passenger, method 300 also includes measuring 316 a biometric characteristic of the passenger and verifying 318 an identity of the passenger based on the biometric characteristic, for example by using an embodiment of passenger identification verification system 15 shown in Figures 1-4. Also in certain embodiments, wherein the specimen being screened is a passenger, method 300 further includes determining 320 a position of the passenger within the screening system 10, comparing 322 the determined position to a desired position, and prompting 324 the passenger to move to the desired position if the determined position does not substantially correspond to the desired position, for example by using an embodiment of passenger position verification system 17 as shown in Figure 12.

The above-described embodiments facilitate examination of passengers for trace particles of a substance, such as explosives, narcotics or other contraband, in an open and relatively well-ventilated space such as a transportation terminal. More specifically, the above-described embodiments advantageously exploit an unexpected benefit of an electromagnetic field screening system by making use of a region of still air created by the electromagnetic shielding for trace particle detection. A technical effect is to facilitate an increase in an accuracy and reliability of trace particle detection at a transportation terminal, with minimal or no increase in a time and a cost required for the overall security screening process.

In addition, the above-described embodiments facilitate improved trace particle detection by virtue of the ability to accurately screen a specimen including the shoes, socks and lower extremities of a passenger. More specifically, the shoes, socks and lower extremities of a passenger involved with contraband are likely to entrain trace particles that have accumulated over time on the floor or ground of a facility where contraband is manufactured, stored or transferred. In addition, trace particles entrained on shoes are likely to remain on the shoes for a substantial period of time relative to trace particles entrained on the passenger's skin or other clothing, which typically are washed and/or changed much more often than are shoes. As a result, the above-described embodiments facilitate trace particle detection from the most promising repository of trace particles on the typical passenger.

Exemplary embodiments of a screening system, including a trace particle detection system, and a method of operating a screening system are described above in detail. The screening system, trace particle detection system and method of operating a screening system are not limited to the specific embodiments described herein, but rather components of the systems and/or steps of the method may be utilized in a different order, or independently and separately from other components and/or steps described herein. For example, the trace particle detection system also may be used on specimens other than passengers and/or in combination with other inspection/detection systems and/or inspection methods, and is not limited to practice with only the screening system as described herein.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A method of operating a screening system, said method comprising:
applying an electromagnetic field to a specimen in a region at least partially enclosed by electromagnetic shielding;
measuring an output from a sensor, the output induced by an interaction of the electromagnetic field and the specimen;
dislodging trace particles from the specimen within the region;
collecting the trace particles;
identifying the trace particles; and
evaluating an association of the specimen with a substance based on the measured sensor output and the identified trace particles.

2. A method in accordance with Claim 1, further comprising detecting conductive objects present on the specimen.

3. A method in accordance with Claim 1 or 2, wherein the specimen comprises a passenger, said method further comprising:
measuring a biometric characteristic of the passenger; and
verifying an identity of the passenger using the biometric characteristic.

4. A method in accordance with any one of Claims 1 to 3, wherein the specimen comprises a passenger, said method further comprising:
determining a position of the passenger within the screening system;
comparing the determined position to a desired position; and
prompting the passenger to move to the desired position if the determined position does not substantially correspond to the desired position.

5. A method in accordance with any one of Claims 1 to 4, wherein said dislodging trace particles from the specimen comprises spraying air into the region.

6. A method in accordance with any one of Claims 1 to 4, wherein said dislodging trace particles from the specimen comprises rubbing a plurality of bristles against the specimen within the region.

7. A method in accordance with Claim 1 or 2, wherein the specimen comprises footwear, and wherein said dislodging trace particles comprises rubbing a plurality of bristles against the footwear within the region.

8. A method in accordance with any one of Claims 1 to 7, wherein said collecting the trace particles comprises capturing air from the region.

9. A method in accordance with any one of Claims 1 to 4, wherein said collecting the trace particles comprises rubbing a plurality of bristles against the specimen within the region and stripping the trace particles from the bristles.

10. A method in accordance with Claim 1 or 2, wherein the specimen comprises footwear, and wherein said collecting the trace particles comprises rubbing a plurality of bristles against the footwear within the region and stripping the trace particles from the bristles.

11. A method in accordance with any one of Claims 1 to 10, wherein said identifying the trace particles comprises analyzing the trace particles in an ion mobility spectrometer.

12. A screening system comprising:
an electromagnetic shield disposed to at least partially enclose a region, said electromagnetic shield is configured to create a barrier to airflow into and out of the region;
a source configured to generate an electromagnetic field within the region;
a sensor configured to produce an output induced by an interaction of the electromagnetic field and a specimen located in the region;
a detector configured to identify trace particles in the region; and
a processor configured to facilitate evaluating an association of the specimen with a substance based on the sensor output and the identified trace particles.

13. The screening system of Claim 12, further comprising one or more nozzles configured to spray air into the region, the sprayed air operative to dislodge trace particles from the specimen within the region.

14. The screening system of Claims 12 or 13, further comprising one or more brushes, each brush comprising a plurality of bristles configured to rub against the specimen, the bristles operative to dislodge trace particles from the specimen within the region.

15. The screening system of Claims 12 or 13, further comprising one or more brushes, wherein the specimen comprises footwear, each brush comprising a plurality of bristles configured to rub against the footwear, the bristles operative to dislodge trace particles from the footwear within the region.

16. The screening system of any one of Claims 12 to 15, further comprising one or more air intakes configured to capture air from the region, wherein said detector is further configured to identify trace particles in the captured air.

17. The screening system of Claim 12, further comprising:
one or more brushes, each of said one or more brushes comprising a plurality of bristles configured to rub against the specimen and thereby capture trace particles from the specimen within the region; and
a stripping device configured to capture the trace particles from said plurality of bristles, wherein said detector is further configured to identify the trace particles captured from said plurality of bristles.

18. The screening system of Claim 12, wherein the specimen comprises footwear, said system further comprising:
one or more brushes, each of said one or more brushes comprising a plurality of bristles configured to rub against the footwear and thereby capture trace particles from the footwear within the region; and
a stripping device configured to capture the trace particles from said plurality of bristles, wherein said detector is further configured to identify the trace particles captured from said plurality of bristles.

19. The screening system of any one of Claims 12 to 18, wherein said detector comprises an ion mobility spectrometer.

20. The screening system of any one of Claims 12 to 19, further comprising a plurality of metal detection coils configured to induce an output in the sensor in response to a conductive object in the region.

21. A computer program embodied on a computer-readable medium, said computer program comprising at least one code segment that configures a processor to:
activate a source to generate an electromagnetic field within a region at least partially enclosed by an electromagnetic shield, the electromagnetic shield configured to create a barrier to airflow into and out of the region;
measure the output of a sensor, the output induced by an interaction of the electromagnetic field and a specimen located in the region;
activate a detector to identify trace particles captured in the region; and
evaluate an association of the specimen with a substance based on the sensor output and the identified trace particles.

22. A computer program in accordance with Claim 21, wherein said at least one code segment further configures the processor to activate one or more nozzles configured to spray air into the region, the sprayed air operative to dislodge trace particles from the specimen within the region.

23. A computer program in accordance with Claim 21, wherein said at least one code segment further configures the processor to activate one or more air intakes configured to capture air from the region.

24. A computer program in accordance with any one of Claims 21 to 23, wherein said at least one code segment further configures the processor to activate a plurality of metal detection coils configured to induce an output in the sensor in response to a conductive object in the region.
